# EUROPEAN PATENT APPLICATION

(11) **EP 3 018 178 A1**
(43) Date of publication of application: **11.05.2016**
(21) Application number: 15000562.7
(22) Date of filing: 27.02.2015
(51) Int. Cl.: C09D 11/322, C09D 11/36, G03F 1/92, G03F 7/00, B41C 1/00

(54) **INK COMPOSITIONS FOR CONTROLLING EXPOSURE IN THREE DIMENSIONS WITHIN A LAYER OF PHOTOPOLYMER, AND METHODS OF USING**

(30) Priority: 10.11.2014 US 201414536708
(71) Applicant: Chemence, Inc., Alpharetta, GA 30005 (US)
(72) Inventor: Maneira, John P., Milton, Georgia 30004 (US)
(74) Representative: Morgan, David James

(57) **Abstract**

The UV opacity from 0 to 100% in one inkjet pass, and the visual color, of solvent-based inks is controlled by the amounts of pigments, dyes, UV blockers and UV brighteners in the inks. The depth-of-cure in photopolymers is controlled by these factors and the % laydown of the ink in one pass.

## Description

### Background of Invention

Field of the Invention:

This invention is in the field of printing, more specifically in the field of making flexographic printing plates and stamps from photopolymers.

Description of the Related Art:

Detailed negatives for exposure of photopolymers in flexo printing plate exposure units have long been produced using inkjet printers to print water-based UV-blocking ink onto pretreated clear plastic films. Except as described in one of the parent applications to this one, until then only water-based inks could be made sufficiently opaque. That invention realized the benefits of printing solvent-based inks on untreated films, such as the fact that untreated films cost about one-tenth that of films treated for use with aqueous inks, and the fact that they are printable with solvent inks at roughly three times the speed of aqueous inks.

In addition, up to now the emphasis has been solely on producing negatives that are sufficiently opaque to UV light to produce good relief images. It has only been necessary to create images at the resolution of a single pixel dot or a single-pixel-width digital line that are either completely transparent or totally opaque to UV light. The formation of such images has been controlled by UV light intensity, time, and the photopolymer chemistry. Such images coincidentally have always blocked visible light, but this is not always helpful to those making or using the plates. An example of this is described in co-pending U.S. Patent Application No. 14/179,634, in which it was found helpful to craft stamp users to print an image on a photopolymer negative that is visible to the eye along with the UV opaque but otherwise invisible image required to create the craft stamp relief image. Expressed more generally, this is a situation in which it is desirable to control light transmission intensity as a function of wavelength as well as being able to control the full range of opacity. There is, therefore, a need to identify and then realize other benefits.

According to one aspect of the present invention, we provide an ink composition, comprising: at least one of: (a) at least one fluorescent substance; (b) at least one light-reflecting substance; and (c) at least one light-absorbing substance; mixed with an organic solvent; the mixture being up to 100% opaque in at least one range of wavelength of UV light when printed on a substrate with a single pass of the printer cartridge and allowed to dry.

Preferably said at least one of (a) at least one fluorescent substance; (b) at least one light-reflecting substance; and (c) at least one light-absorbing substance is (b) at least one light absorbing substance.

Suitably said at least one light-absorbing substance comprises at least one UV absorber and at least one visible light absorber.

Conveniently one UV absorber in the amount of up to about 1% by weight; and
visible light absorbers comprising up to about 1% by weight of black pigment, up to about 1% by weight of yellow pigment, and up to about 1% by weight of cyan pigment.

Preferably said at least one fluorescent substance is present up to about 1% by weight; and
said at least one light-absorbing substance comprises at least 1% by weight of black pigment, at least 1% by weight of yellow pigment, and at least 1% by weight of cyan pigment.

According to another aspect of the present invention we provide a method of controlling photopolymer exposure, the method comprising the steps of (a) loading at least one ink cartridge with an ink of claim 1; (b) placing the at least one ink cartridge in a printer; (c) causing the printer to print an ink pattern from the at least one ink cartridge on at least one plastic sheet; and (d) exposing a photopolymer layer to UV light through the at least one plastic sheet.

Preferaby said ink pattern comprises first UV filtering areas having 100% opacity to UV light;
second UV filtering areas having less than 100% opacity to UV light; and visible light filtering areas having up to 100% opacity in at least one wavelength of visible light.

Suitably step (a) is loading at least one ink cartridge with an ink.

Conveniently step (a) is loading at least one ink cartridge with an ink.

Preferably said first UV filtering areas are printed with at least about 80% laydown; and
said second UV filtering areas are printed with about 15% laydown.

Suitably step (c) is causing the printer to print a first ink pattern from the at least one ink cartridge on a first plastic sheet; and (d) is exposing a photopolymer layer to UV light on an exposure unit through the first plastic sheet in one direction; and further comprises the steps of: (e) causing the printer to print a second ink pattern from the at least one ink cartridge on a second plastic sheet; and (f) exposing the photopolymer layer to UV light on the same exposure unit through the second plastic sheet in the opposite direction.

Conveniently said second ink pattern has up to 100% opacity to UV light.

According to a further aspect of the present invention an article of manufacture comprises
a plastic sheet printed with a pattern of solvent-based ink; the pattern comprising at least one first UV filtering area having 100% opacity to UV light; at least one second UV filtering area having less than 100% opacity to UV light; and at least one visible light filtering area having up to 100% opacity in at least one wavelength of visible light.

According to a yet further aspect of the present invention an article of manufacture, comprises a plastic sheet having an upper surface; the exposed photopolymer layer produced being affixed to the upper surface of the plastic sheet; the layer comprising first areas of cured photopolymer, a first height above the upper surface; second areas of cured photopolymer, a second height above the upper surface; and third areas of cured photopolymer, a third height above the upper surface.

Preferably said first areas are a watermark; said second areas are floor areas and said second height is higher than said first height; and said third areas are relief areas and said third height is higher than said second height.

### Brief Description of the Invention

The present invention uses inkjet technology, preferably software-controlled, to control the intensity and wavelength of the radiation exposing the photopolymer beyond simply "on" or "off." The amount of UV blockers and the "color" of UV absorbers can now be controlled dot-by-dot, so that polymerization can be controlled in three dimensions within a photopolymer layer, that is, not only in the print and cross-print directions but also by depth of cure.

### Brief Description of the Drawings

Figure 1 is a cross-sectional illustration of the layers of film, substrate and photopolymer arranged in accordance with the prior art method of making a flexographic I-Plate.
Figure 2 is an exploded view of the separated layers of a sheet of craft stamps produced in accordance with the prior art.
Figure 3 is an exploded view of making an ink print using a stamp made according to the prior art method.
Figure 4 is a cross-sectional illustration of the layers of film, substrate and photopolymer arranged in accordance with the present invention for making a sheet of craft stamps.
Figure 5 is an exploded view of the separated layers of a sheet of craft stamps produced with the present invention.
Figure 6 is a cross-sectional illustration of the layers of materials used to produce a watermark in a flexographic printing plate with the present invention.
Figure 7 is an oblique photograph of a portion of the upper surface of a substrate printed with a masking image and a watermark image in accordance with the present invention.
Figure 8 is an oblique photograph of a portion of the flexo plate produced from the printed substrate shown in Figure 7.

### Detailed Description of the Invention

The instant invention enables untreated polymeric films (e.g., polyester) to be used for photopolymer exposure, more specifically flexo plate and stamp making, by augmenting the ability of solvent-based inkjet inks to partially transmit or completely block actinic radiation in the UV spectrum (240 to 360 nm) and visible spectrum (390 to 700 nm). This is accomplished by adding either brightening compounds or light-absorbing or -reflecting compounds such as dyes and pigments (or combinations of these) to the ink.

The light absorbing compounds behave like dyes or pigments, while the brighteners work by reflecting incident radiation away from the negative during exposure of the plate. Optical brighteners create brilliance by absorbing UV light, modifying the wavelength of the light and then emitting the light by fluorescence, typically in a visible wavelength. In this instance the benefit is the UV light absorption by the fluorescent material preventing it from penetrating the film and/or transforming the UV into wavelengths that do not cure the photopolymer.

The instant invention and examples are directed at producing solvent-based inkjet negatives for the purpose of controlling UV exposure in flexo plate and stamp manufacture. They also apply to other apparatuses and processes in which it would be advantageous to control light penetration, or exposure of other photo-reactive materials, using various combinations of light transmission altering substances.

### Example I. Use of Solvent Ink Additives to Create UV-Opaque Images for Flexo Plate Making

The most basic use of combinations of brighteners and absorbers in solvent-based inks is to make solvent ink images on film comparably opaque to aqueous ink images in liquid photopolymer flexo plate making processes. This is disclosed in U.S. patent application no. 13/902,301, which is incorporated into the instant application in its entirety and constitutes the first embodiment of the instant invention. Experimental data in that application disclose that while blue-dyed solvent ink by itself only reduces UV transmission by about 50%, addition of a UV-Bright® brightener to the ink in the amount of 5000 ppm lowers the UV transmission 28.3% further. The desired prophetic result of 30% further decrease in UV penetration could be realized by a small increase in the concentration of brightener, as shown in Table I below. The brightener blocks the UV by converting it to visible wavelengths, which happens to be of no consequence in this application because the visual appearance does not matter.

**TABLE I**

| UV Light Transmission vs. Blue Dye Control, UV Blockers. and UV Brighteners | | | | | | | |
|---|---|---|---|---|---|---|---|
| **UV MASK for Solvent BLUE DYE - 0.5% (5000ppm) Addition (01-24-2013)** | | | | | | | |
| | **Light Source:** | **UVITRON*** | | | **IDEAL**** | | |
| | | **UV-Transparency** | | | **UV-Transparency** | | |
| | **Sample** | Light Intensity: mW/cm² | % Transmission | % Decrease | Light Intensity: mW/cm² | % Transmission | % Decrease |
| **1.** | Empty | 2.53 | | | 1.281 | | |
| **2.** | 2-Glass Slides | 2.17 | 100 | 0 | 0.988 | 100 | 0 |
| **3.** | Blue Dye - Control | 1.011 | 46.6 | baseline | 0.326 | 33.0 | baseline |
| **4.** | *Tinuvin P 5000ppm* | 0.913 | 42.1 | 4.5 | 0.298 | 30.2 | 2.8 |
| **5.** | *Tinuvin 328 - 5000 ppm* | 0.467 | 21.5 | 25.1 | 0.135 | 13.7 | 19.3 |
| **6.** | *Tinuvin 5151 - 5000 ppm* | 0.505 | 23.3 | 23.3 | 0.233 | 23.6 | 9.4 |
| **7.** | UV-Bright. 406 - 5000 ppm | 0.47 | 21.7 | 24.9 | 0.0648 | 6.6 | 26.4 |
| **8.** | UV-Bright. 4059-5000 ppm | 0.397 | 18.3 | 28.3 | 0.091 | 9.2 | 23.8 |
| **9.** | **Prophetic Result** | **0.360** | **16.6** | **30.0** | **0.030** | **3.0** | **30.0** |

| | | | | | | | |
|---|---|---|---|---|---|---|---|
| * Intelli-Ray 400 Exposure Unit ** 1200 Stamp Exposure Unit | | | | | | | |

As more fully disclosed in the parent application 13/902,301, these inks, being solvent-based, adhere to untreated substrates and films such as polyester and polyvinylethylene. Such untreated materials are considerably less expensive that those required for printing with water-based inks.

### Example II. Use of Solvent Ink Additives to Invert the Opacity of the Visual Image from That of the UV Image

Similar technology can be used not only to render a sufficiently opaque UV "negative" image on a film, but also to make the visual appearance of that image a "positive" of the same image, or, in other words, make the areas on the film that are opaque to UV light appear clear to the eye, and vice-versa. This is the subject of U.S. patent application no. 14/179,634, which is incorporated into this application in its entirety and constitutes the second embodiment of the instant invention. This embodiment can be thought of as controlling the opposite end of the light spectrum from the first embodiment and is being successfully used to make indexing images for craft stamps.

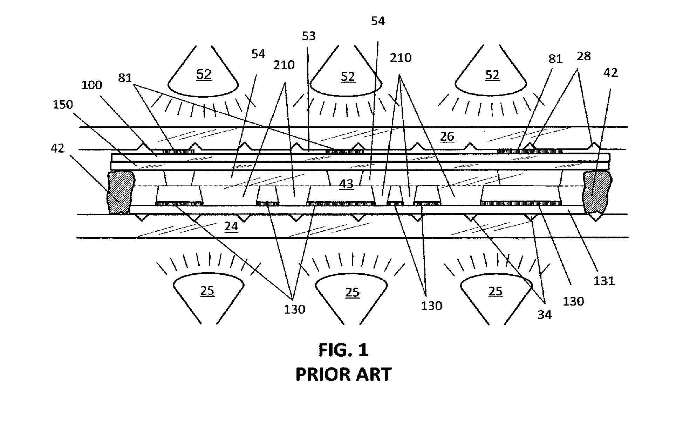

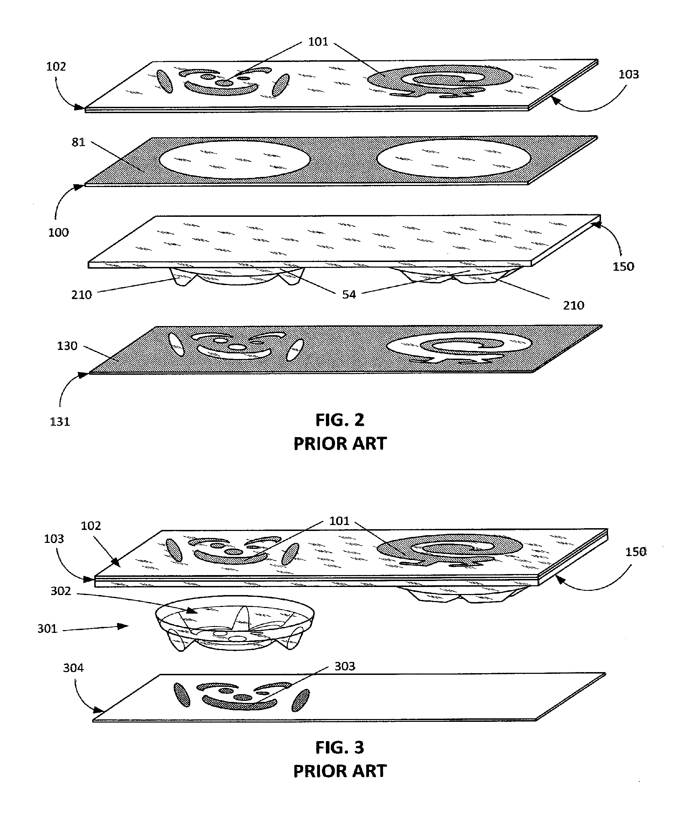

A cluster of craft stamps of a certain theme or style are typically produced together on one sheet of substrate from a photopolymeric procedure. The stamps have a clear, thin backing sheet upon which an island plate (or "I-plate") has been developed by exposure to UV light. Each stamp is a relief image supported by an island image floor which acts as a webbing to hold together thin elements of the relief. Once developed, the cluster of stamps is sold right on the substrate. Referring now to the drawings, which are not to scale, and in which like reference characters refer to like elements among the drawings, Figure 1 is a cross-sectional illustration of a prior art method for making an I-plate suitable for a cluster of stamps. The steps involved are as follows:
(a) Print the stamp floor (masking) images 81 on a clear masking film 100;
(b) Print the stamp relief images 130 on a clear relief image film 131;
(c) Print the stamp images 101 on a clear indexing image sheet 102 (not visible in this view, see Fig. 2);
(d) Apply a layer of adhesive (not visible in this view) to the underside of the indexing image sheet 102;
(e) Place the relief image film 131 with the relief images 130 on the bottom glass 24 of the UV exposure unit (preferably, but not essentially, with the image side facing up);
(f) Optionally cover the relief image film 131 with a protective cover film (not shown);
(g) Optionally pull a vacuum in lower vacuum grooves 34 to remove air from under image film 131;
(h) Cast a layer of liquid photopolymer 43 adjacent to the relief image film 131 (employing dams 42 if necessary);
(i) Place a clear substrate 150 in contact with the upper surface of the liquid photopolymer layer 43;
(j) Place the printed masking film 100 on top of the clear substrate 150 (registering the mask image properly with respect to the relief image);
(k) Optionally pull a vacuum in upper vacuum grooves 28 to remove air from between upper glass 26, masking film 100, and substrate 150;
(l) Shine polymerizing light 52 through the clear (unprinted) areas 53 in the masking film 100 for an amount of time suitable to form polymerized floor images 54 of a desired thickness in the liquid photopolymer;
(m) Shine polymerizing light 25 through the relief images 130 for an amount of time suitable to form polymerized relief images 210 in the liquid photopolymer between the polymerized floor images 54 and the relief images 130;
(n) (Not shown) Remove the above layers from the exposure unit and perform post-exposure treatment; and
(o) (Not shown) Glue the indexing image sheet 102 to the clear substrate 150 (registering it properly with respect to the relief image).

Figure 2 is a perspective illustration of the separated layers of a prior art sheet of craft stamps produced after the exposure shown in Fig. 1 is fully cured and post-treated. The masking film 100 with its masking image 81, and the relief film 131 with its relief images 130, produce the stamp floor images 54 and the stamp relief images 210 during exposure to UV light. They are removed from the substrate 150 and the stamp relief images 210, respectively, and are discarded or reused. Fig. 2 also shows the clear indexing image sheet 102 that is typically thermally printed with the black index images 101 that are congruent to the ink image that will be printed by the stamp. This has an adhesive layer 103 applied to its underside so that it can be affixed to the clear top 104 of the stamp substrate 150. This is a labor-intensive step because the sticky image sheet 102 must be applied manually in exact registration with the stamp relief images 210 underneath.

Figure 3 is a perspective illustration of making an ink print 303 using a stamp 301 made according to the prior art method. The black indexing images 101 visible on top of the indexing image sheet 102 (with its adhesive layer 103 attached to clear substrate 150) show the user what will be printed with a particular stamp. The stamp 301, which has a tacky upper surface 302 after the photopolymer is cured, has been peeled off of the substrate 150, temporarily applied to a clear plastic stamp tool (not shown), inked, and used to make an ink image 303 on a sheet of, e.g., paper 304.

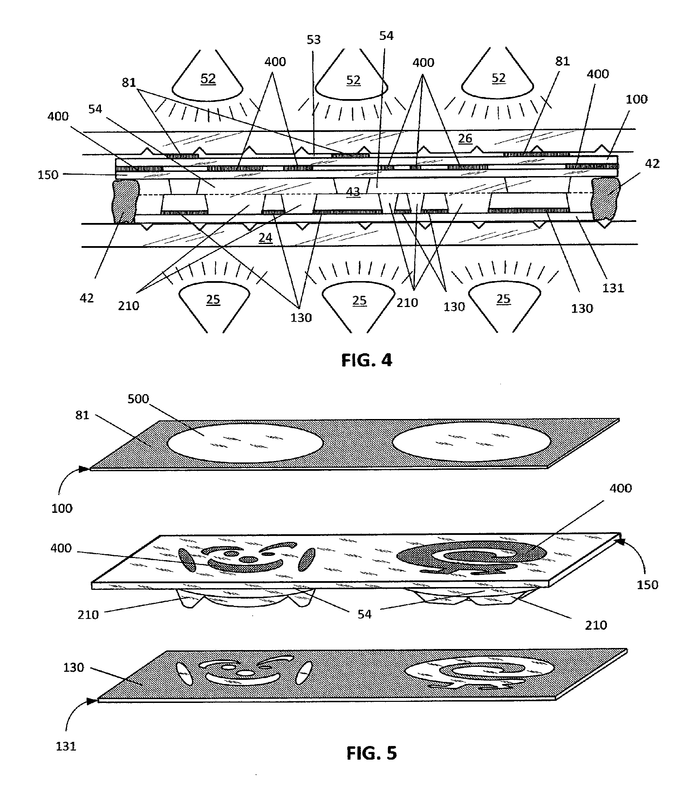

Figure 4 is a perspective illustration of the layers of a sheet of craft stamps made in accordance with the second embodiment of the present invention. It is similar to Fig. 1 except that indexing images 400 have been inkjet printed on the substrate 150 before the substrate 150 was placed on top of the photopolymer layer 43. Note that the widths of the indexing images 400 in this view exactly match the widths of the bottoms of the polymeric stamp relief images 210, meaning that the 2-D shapes of the indexing images 400 on the surface of substrate 150 matches those of the relief images 210. (This is more fully described in the following Fig. 5.)

The steps in this process are:
(a) Print the masking images 81 on a masking film 100;
(b) Print the stamp relief images 130 on a relief image film 131;
(c) Print an indexing image 400 on a substrate 150;
(d) Place the relief image film 131 on the bottom glass 24 of the UV exposure unit;
(e) Optionally cover the relief image film 131 with a protective film (not shown);
(f) Pull a vacuum in the lower vacuum grooves to remove air from under image film 131;
(g) Cast a layer of liquid photopolymer 43 adjacent to the relief image film 131;
(h) Place the clear substrate 150 in contact with the upper surface of the liquid photopolymer layer 43;
(i) Place the printed masking film 100 on top of the clear substrate 150;
(j) Lower the lid on the UV exposure unit and optionally pull a vacuum in the upper vacuum grooves to remove air from between upper glass 26, masking film 100, and substrate 150;
(k) Shine polymerizing radiation 52 through the masking film 100 for an amount of time suitable to form polymerized floor images 54 of a desired thickness in the liquid photopolymer;
(l) Shine polymerizing radiation 25 through the relief images 130 for an amount of time suitable to form polymerized relief images 210 in the liquid photopolymer between the polymerized floor images 54 and the relief images 130;
(m) Remove the above materials from the exposure unit;
(n) Remove the masking film 100 and the relief image film 131 from the materials; and
(o) Clean the polymerized material and substrate 150.

Figure 5 is a perspective illustration of the separated layers of a sheet of craft stamps produced after the exposure shown in Fig. 4 is fully cured and post-treated. This figure shows more clearly the images of the present invention and the method of making them. As before, the masking film 100 with its masking image 81, and the relief film 131 with its relief images 130, produce the polymeric stamp floor images 54 and stamp relief images 210 during exposure to UV light. As before, they are removed from the substrate 150 and the stamp relief images 210, respectively, and are discarded or reused. However, in accordance with the present invention, indexing images 400 have now been printed on the upper surface of the substrate 150. The inks used to produce the indexing images is solvent-based and may contain varying amounts of wavelength-specific light blockers and filters. In this second embodiment of the invention the ink blocks light in the visible spectrum (390 to 700 nm wavelength) while being transparent or translucent to the shorter ultraviolet wavelengths. This allows UV light entering through the UV-transmitting areas 500 in the masking film 100 to create the same stamp floor images 210 unimpeded. The substrate 150 must be compatible with the solvent ink formula, namely polyvinylethylene, polyethylene, polyvinyl chloride, certain other vinyl-based polymers or polyester, but any ink-compatible film may be used within the scope of this invention without limitation.

### Example III. Use of Solvent Ink Additives to Create a Flexo Plate Watermark

The third embodiment of the instant invention stems from the discovery that variations between the above two extremes would allow micro-control of UV light transmission and therefore permit physical control of depth-of-cure at all points on a photopolymer plate. A methodology has been developed for imaging photopolymer flexographic printing plates using solvent-based ink formulation and software control of laydown to control and filter UV light intensity.

An example of this embodiment replaces current methods of "watermarking" a photopolymer plate. "Watermarking" a flexo plate refers to marking a plate with some kind of image of the manufacturer's choosing, such as a logo or lot number. Such an image must be created in an area of the plate that has no print relief on it. Prior art methods involve a separate step of applying or engraving the name or logo somewhere on the plate, where there is no print relief, regardless of whether it is done before or after the plate is exposed to UV light. This third embodiment allows a flexo plate to be watermarked while it is initially made, eliminating the separate step.

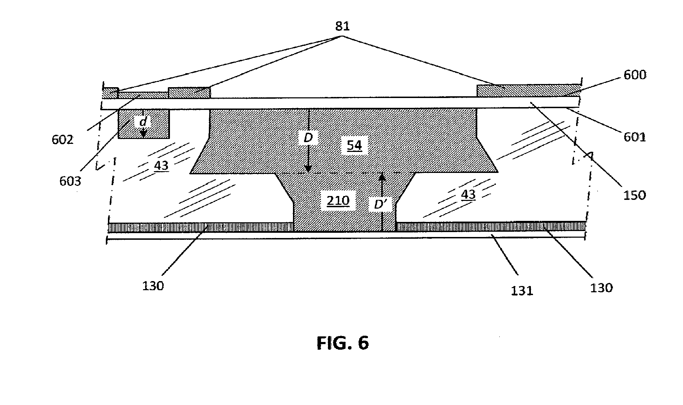

Fig. 6 is a cross-sectional illustration of the layers of materials used to produce a watermark in a flexographic printing plate in accordance with this third embodiment. Using a solvent ink of the first embodiment, a masking image 81 is printed on the upper surface 600 of a solvent ink-compatible substrate 150, such as polyester. The ink is formulated, by way of example, from sufficient Tinuvin® pigment and/or UV-Bright® brightener to render the ink opaque to UV light at the intensity provided by the exposure unit to be used. Likewise, a relief image negative 130 is printed on a solvent ink compatible clear relief image film 131, such as polyvinylethylene. These printed images are then used as described in Figure 1 to develop photopolymeric floor images 54 and relief images 210 in a layer of liquid photopolymer 43. Because the inkjet images are opaque, none of the photopolymer 43 that is shielded from the UV is polymerized. The clear areas are exposed to UV long enough to cure the floor images 54 and relief images 210 to depths D and D', respectively sufficient to join them into a contiguous solid attached to the bottom surface (in this view) 601 of the substrate 150. The element of invention that distinguishes this embodiment from the first embodiment is that by controlling ink laydown, a thin ink watermark image 602 is printed on the substrate 150 at the same time the masking image 81 is created. The laydown is easily controlled by the software governing discharge of ink from the cartridge in a continuous range from 0 to 100%, with 100% representing the maximum amount achievable in one pass. With the new solvent ink technology represented by this invention and its parent U.S. patent application no. 13/902,301, complete opacity to UV light is achievable in one pass of a printer cartridge discharging as little as 80% laydown of ink. The watermark relief 603 can be produced by, e.g., 15% laydown of the same ink formulation. When UV light is shone from above the substrate 150, an amount of UV light smaller than the unblocked light passing through the un-inked area 53 gets through the image 602 during the exposure time. This allows photopolymer curing below it to a depth d. Such a shallow relief 603 is visible to the eye but cannot interfere with printing on the press because its height d above the substrate is even less than that D of floor. To make it more visible, the watermark can be tinted by a choice of solvent-miscible dyes and/or pigments.

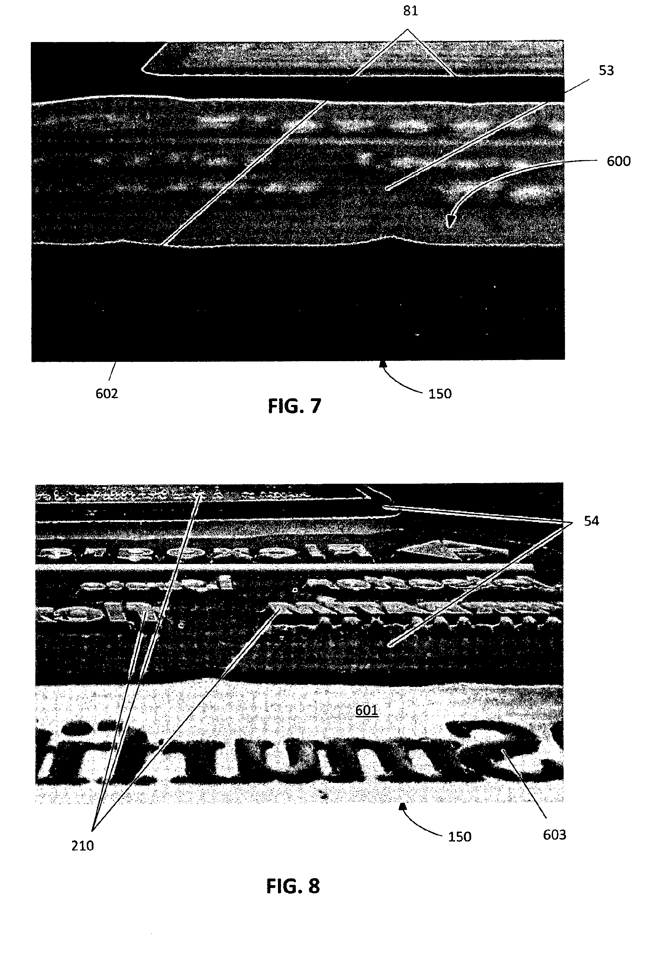

Figure 7 is an oblique photograph of a portion of the upper surface 600 of a substrate 150 printed with a I-plate masking image 81 plus a watermark image 602 using solvent-based ink in accordance with the present invention. The masking image 81 is produced by a UV-opaque formulation, which appears in the visual spectrum as the darkest areas here. The nearly white areas 53 allow enough UV light during the exposure time to pass through to completely polymerize the photopolymer below to the desired depth of cure for the floor areas. The watermark image 602 in this case is the same ink printed with above-mentioned thinner laydown, so as to allow less UV to pass through in the same exposure time. The depth of cure below these areas will therefore less than that of the floor.

Figure 8 is an oblique photograph of a portion of the flexo plate produced from the printed substrate shown in Figure 7 exposed from above and a printed relief image film (see Fig. 1) exposed from below. The polymerized floor areas 54 have been formed on the bottom surface 601 of the substrate 150 and are contiguous with the polymerized relief images 210. (The relief image film has been peeled off of the top surface of the relief and discarded.) Also formed on the surface 601 is the watermark 603.

Thus is it clear that this third embodiment of the instant invention uses ink formulation, namely a combination of dyes, pigments, UV absorbers and/or UV brighteners to act as a UV filter (not merely a 100% UV block) to control the depth of cure (the third dimension of photopolymer exposure) at any 2-D location on the plate.

### Example IV. Use of Solvent Ink Additives to Micro-Control UV Light Transmission Generally

Like water-based inks, solvent inks are tinted for printing using the CYMK subtractive color model. As discussed above, the inability of any CYMK combination to render a substrate or film opaque to UV led to the discovery that adding UV blockers and/or brighteners to solvent inks could make them opaque to UV and thus suitable for photopolymer imaging. It was also discovered that certain combinations of CYMK dyes and pigments unexpectedly produced effects in the ultraviolet spectrum counter-intuitive to those achieved by simple addition of colors. For example, a blend of cyan, yellow and black, which appears dark green, blocks more UV than any amount of pure black. Conversely, films and substrates printed to control photopolymer exposure may be tinted for various visual imaging purposes. CYMK dyes or pigments can be selected, for example, to display a color preview of a halftone on the substrate. However, the color combinations necessary to produce such visual images using this fourth embodiment may differ from those one would otherwise select from the CYMK palette because they must also contain a UV blocker or brightener.

## Claims

1. An ink composition, **characterised in**: at least one of: (a) at least one fluorescent substance;
(b) at least one light-reflecting substance; and (c) at least one light-absorbing substance; mixed with an organic solvent; the mixture being up to 100% opaque in at least one range of wavelength of UV light when printed on a substrate with a single pass of the printer cartridge and allowed to dry.

2. An ink composition as claimed in claim 1, **characterised in** said at least one of (a) at least one fluorescent substance; (b) at least one light-reflecting substance; and (c) at least one light-absorbing substance; and (b) is at least one light absorbing substance.

3. An ink composition as claimed in claim 1 or claim 2 chararacterised in that said at least one light-absorbing substance comprises at least one UV absorber and at least one visible light absorber.

4. An ink composition as claimed in any of claims 1 to 3, **characterised in that** one UV absorber in the amount of up to about 1% by weight; and visible light absorbers comprising up to about 1% by weight of black pigment, up to about 1% by weight of yellow pigment, and up to about 1% by weight of cyan pigment.

5. An ink composition as claimed in any of claims 1 to 4, **characterised in that** said at least one fluorescent substance is present up to about 1% by weight; and said at least one light-absorbing substance comprises at least 1% by weight of black pigment, at least 1% by weight of yellow pigment, and at least 1% by weight of cyan pigment.

6. A method of controlling photopolymer exposure, **characterised in** comprising the steps of: (a) loading at least one ink cartridge with an ink as claimed in claim 1; (b) placing the at least one ink cartridge in a printer; (c) causing the printer to print an ink pattern (81) (400) (130) from the at least one ink cartridge on at least one plastic sheet (100) (150) (131); and (d) exposing a photopolymer layer to UV light (25) (52) through the at least one plastic sheet.

7. A method as claimed in claim 6, chararacterised in that said ink pattern (81) (400) (130) comprises first UV filtering areas (130) (81) having 100% opacity to UV light; second UV filtering areas (400) (602) having less than 100% opacity to UV light; and visible light filtering areas (400) (81) having up to 100% opacity in at least one wavelength of visible light.

8. A method as claimed in claim 7, **characterised in that** step (a) is loading at least one ink cartridge with an ink as claimed in claim 3.

9. A method as claimed in claim 8, **characterised in that** step (a) is loading at least one ink cartridge with an ink as claimed in claim 5.

10. A method as claimed in claim 7, **characterised in that** said first UV filtering areas (130) (81) are printed with at least about 80% laydown; and said second UV filtering areas (400) (602) are printed with about 15% laydown.

11. A method as claimed in claim 7, **characterised in that** step (c) is causing the printer to print a first ink pattern (130) from the at least one ink cartridge on a first plastic sheet (131); and (d) is exposing a photopolymer layer (43) to UV light (25) on an exposure unit through the first plastic sheet (131) in one direction; and further comprises the steps of: (e) causing the printer to print a second ink pattern (81) (400) from the at least one ink cartridge on a second plastic sheet (100) (150); and (f) exposing the photopolymer layer to UV light (52) on the same exposure unit through the second plastic sheet in the opposite direction.

12. A method as claimed claim 11, **characterised in that** said second ink pattern (81 (400) has up to 100% opacity to UV light.

13. An article of manufacture, **characterised in** comprising a plastic sheet (150) printed with a pattern of solvent-based ink (81) (602); the pattern comprising at least one first UV filtering area (81) having 100% opacity to UV light; at least one second UV filtering area (602) having less than 100% opacity to UV light; and at least one visible light filtering area (81) (602) having up to 100% opacity in at least one wavelength of visible light.

14. An article of manufacture, **characterised in** comprising: a plastic sheet (150) having an upper surface (601);
the exposed photopolymer layer (43) produced by the method as claimed in claim 11 affixed to the upper surface of the plastic sheet (150); the layer comprising first areas of cured photopolymer (603), a first height (*d*) above the upper surface; second areas of cured photopolymer (54), a second height (*D*) above the upper surface; and third areas of cured photopolymer (210), a third height (*D*+*D*') above the upper surface.

15. An article of manufacture as claimed in claim 14, **characterised in that** said first areas (603) are a watermark;
said second areas (54) are floor areas and said second height (*D*) is higher than said first height (*d*); and said third areas (210) are relief areas and said third height (*D*+*D*') is higher than said second height.
